# EUROPÄISCHE PATENTSCHRIFT

(11) **EP 4 002 968 B1**
(45) Veröffentlichungstag und Bekanntmachung des Hinweises auf die Patenterteilung: **07.08.2024**
(21) Anmeldenummer: 21205139.5
(22) Anmeldetag: 28.10.2021
(51) Int. Cl.: H05K 7/14, H05K 7/20

(54) **UMRICHTER UND VERFAHREN ZU SEINER HERSTELLUNG**
INVERTER AND METHOD FOR THE PRODUCTION OF SAME
ONDULEUR ET SON PROCÉDÉ DE FABRICATION

(30) Priorität: 24.11.2020 DE 102020131009
(43) Veröffentlichungstag der Anmeldung: 25.05.2022
(73) Patentinhaber: STILL GmbH, 22113 Hamburg (DE)
(72) Erfinder: SCHETTGEN, Nils, 22559 Hamburg (DE); WILHÖFT, Adolf, 22885 Barsbüttel (DE); GRAF VON HELLDORFF, Sören, 27432 Oerel (DE)
(74) Vertreter: Patentship Patentanwaltgesellschaft

(56) Entgegenhaltungen:
- EP-A2- 2 916 634
- WO-A1-2019/064896
- DE-A1- 102012 001 917
- JP-A- 2007 295 639
- US-A- 5 485 350
- US-A1- 2007 231 165

## Beschreibung

Die Erfindung betrifft einen Umrichter, insbesondere einen mehrphasigen Drehstromumrichter, mit einem Gleichspannungszwischenkreis und einem, mindestens einen Leistungshalbleiter aufweisenden, Leistungsmodul, wobei der Gleichspannungszwischenkreis und das Leistungsmodul auf einer gemeinsamen Leiterplatte untergebracht sind, wobei die Leiterplatte in einem deckelartigen Gehäuseteil fixiert ist und das deckelartige Gehäuseteil auf einem Kühlkörper montiert ist.

Mehrphasige Umrichter, beispielsweise dreiphasige Wechselrichter oder Frequenzumrichter, werden zur Speisung von mehrphasigen elektrischen Antriebsmaschinen aus einer Gleichspannungsquelle verwendet. Eingesetzt werden derartige Umrichter beispielsweise als Frequenzumrichter, die aus einer Gleichspannungsquelle einen Fahrmotor, beispielsweise einen Asynchronmotor, eines elektrisch angetriebenen Fahrzeugs, etwa eines Flurförderzeugs, ansteuern.

Die Gleichspannung kann aus einer Batterie oder einem Generator als Gleichspannungsquelle bereitgestellt werden. Als Generator kann ein Gleichspannungsgenerator oder ein Drehstromgenerator eingesetzt werden, dessen erzeugter Drehstrom in einem Gleichrichter gleichgerichtet wird.

Bei Umrichtern, die insbesondere für einen Fahrantrieb vorgesehen sind, werden von den Leistungshalbleitern des Leistungsmoduls sehr große Ströme geschaltet und es entsteht viel Abwärme durch die Verlustleistung. Daher ist es ein bekannter Aufbau, die Leistungshalbleiter direkt an einem Kühlkörper anzuordnen, der einen Teil des Gehäuses des Umrichters bildet. Um zugleich über Leistungsstromanschlüsse die hohen Ströme des Gleichspannungszwischenkreises zuführen sowie die einzelnen Phasen des mehrphasigen Stromes des Leistungsmoduls abführen zu können, werden häufig zusätzliche Stromschienen eingesetzt. Dadurch können erst große Leiterquerschnitte erreicht werden, die mit Leiterbahnen auf Platinen bzw. Substraten nur schwer zu verwirklichen sind.

Auch wird dadurch die Zu- und Abführung der Leistungsstromanschlüsse erleichtert, wenn oberhalb des Leistungsmoduls mit den Leistungshalbleitern in einer zweiten Ebene auf einer weiteren Platine der Gleichspannungszwischenkreis mit den anderen Bauteilen des Umrichters, wie insbesondere die Glättungskondensatoren, angeordnet werden. In diesem Fall ist es möglich, die Leistungsstromanschlüsse bzw. Stromschienen durch Aussparungen dieser Platine in der zweiten Ebene hindurch direkt nach unten zu den Leistungshalbleitern, insbesondere Leistungstransistoren, zu führen, etwa durch Schraubenbolzen oder Druckhülsen, die bis zu einer unteren, ersten Platine mit den Leistungstransistoren, die an dem Kühlkörper angeordnet ist, hindurchgeführt sind.

Durch die Verwendung von Stromschienen ist es auch möglich, die Ausbildung von elektromagnetischen Feldern innerhalb des Umrichtergehäuses in einem gewissen Maß zu steuern.

Für die Steuerung des Umrichters sind Stromsensoren erforderlich, die die in den Leistungsstromanschlüssen fließenden Ströme erfassen. Hierfür sind Stromsensorkerne bekannt, die als weichmagnetisches Material, beispielsweise Blechpakete, den Stromleiter umschließen und einen Spalt aufweisen. In diesem Spalt wird dann ein Magnetsensor, insbesondere ein Hallsensor angeordnet, über den indirekt über die sich bildenden Magnetfelder die fließenden Ströme erfasst werden können.

Nachteilig an diesem Stand der Technik ist, dass bei der Endmontage des Umrichters die Stromschienen wie auch die Stromsensoren als einzelne Bauelemente bzw. nachträglich in den bereits teilmontierten Umrichter eingebracht und befestigt werden müssen. Dadurch entsteht erheblicher Aufwand, angefangen von der notwendigen Lagerhaltung der diversen einzelnen Teile bis zur erforderlichen Arbeitszeit im Rahmen der Endmontage. Auch ist es erstrebenswert, die eigentlichen Sensorelemente, insbesondere die bereits beschriebenen Hallsensoren, auf einer im Regelfall vorgesehenen zusätzlichen Steuerplatine anzuordnen und zu befestigen, etwa durch auflöten oder verkleben. Nach dem Stand der Technik ist dann jedoch eine einfache Montage durch Einsetzen der Steuerplatine nicht ohne weiteres möglich, wenn diese Sensorelemente in den Spalt der Stromsensorkerne eingesetzt werden müssen. Weiterhin ist bekannt, ein unteres Gehäuseteil als umlaufenden Druckrahmen so vorzusehen, dass dieser die erste Platine mit den Leistungshalbleitern gegen den Kühlkörper drücken kann.

Aus der EP 1 083 599 B1 ist ein Umrichter bekannt, bei dem der elektrische Gleichspannungszwischenkreis von einer Leiterplatte gebildet ist, die oberhalb eines Leistungsmoduls angeordnet ist. Das Leistungsmodul besteht aus mehreren identisch aufgebauten rechteckförmigen Substraten, die an den Längsseiten mit elektrischen Kontaktflächen versehen sind. Die Substrate werden nebeneinander derart angeordnet, dass zwei nebeneinander liegende Kontaktflächen zweier benachbarter Substrate auf demselben Potential liegen und durch eine Anpressvorrichtung in Form von elektrisch leitenden Druckstücken elektrisch kontaktiert werden können. Die Druckstücke dienen weiterhin zur Anpressung der Substrate an einen Kühlkörper, um eine Kühlung der Leistungshalbleiter sicherzustellen.

In der DE 10 2009 053 997 A1 ist ein Umrichter beschrieben, bei dem der Gleichspannungszwischenkreis von einer plattenförmigen Platine und das Leistungsmodul von einer Leiterplatte gebildet sind, die in parallelen Ebenen direkt übereinander angeordnet sind und mittels Lötstiften elektrisch und mechanisch miteinander verbunden sind.

Aus der US 2006/0007721 A1 ist ein Leistungsumrichter bekannt, bei dem Leiterelemente in einen Kunststoffrahmen im Spritzgussverfahren eingefügt sind. Nachteilig an diesem Stand der Technik ist, dass keine Lösung für eine effiziente und einfache Montage der Stromsensoren offenbart wird.

In der DE 10 2014 103 109 A1 ist ein Umrichter beschrieben, bei dem die Leistungsstromanschlüsse des Gleichspannungszwischenkreises sowie des Leistungsmoduls in einem Gehäuseabschnitt aus einem Gehäuse des Umrichters herausgeführt sind, wobei der Gehäuseabschnitt aus isolierendem Spritzgussmaterial besteht und die Leistungsstromanschlüsse von dem Spritzgussmaterial in der Durchführung umspritzt und mit diesem fest verbunden sind, wobei ein Stromsensorring mindestens einen der Leistungsstromanschlüsse umschließend zumindest teilweise in dem Spritzgussmaterial angeordnet ist.

Ein gattungsgemäßer Umrichter mit den Merkmalen des Oberbegriffs des Patentanspruchs 1 ist aus der JP 2007 295639 A1 bekannt.

Die WO 2019/064896 A1 offenbart einen Elektromotor, an dessen Gehäuse eine den Elektromotor steuernde Leiterplatte eines Umrichters angeordnet ist.

Die US 5 485 350 A offenbart ein Gehäuse mit einem darin angeordneten Umrichter.

Die DE 10 2012 001 917 A1 offenbart ein elektrisches Gerät, mit einer in einem Gehäuse angeordneten Leiterplatte.

Die US 2007/231165 A1 offenbart einen elektrischen Kompressor, bei dem am Gehäuse ein Aufnahmeraum ausgebildet ist, in dem ein den Elektromotor des Kompressors ansteuernder Umrichter angeordnet ist.

Der vorliegenden Erfindung liegt die Aufgabe zugrunde, einen Umrichter der eingangs genannten Art so auszugestalten, dass ein kostengünstiger Aufbau mit geringem Montageaufwand ermöglicht wird.

Diese Aufgabe wird durch einen Umrichter, insbesondere mehrphasigen Drehstromumrichter, mit einem Gleichspannungszwischenkreis und einem, mindestens einen Leistungshalbleiter aufweisenden, Leistungsmodul gelöst, wobei der Gleichspannungszwischenkreis und das Leistungsmodul auf einer gemeinsamen Leiterplatte untergebracht sind, wobei die Leiterplatte in einem deckelartigen Gehäuseteil fixiert ist und das deckelartige Gehäuseteil auf einem Kühlkörper montiert ist, wobei im deckelartigen Gehäuseteil Anschlussbolzen von Leistungsstromanschlüssen des Gleichspannungszwischenkreises und des Leistungsmoduls integriert sind.

Durch die Integration von Steuer- und Leistungselektronik auf einer einzigen Leiterplatte kann eine besonders kompakte und kostengünstige Bauweise des Umrichters mit geringem Montageaufwand erreicht werden. Während beim Stand der Technik, bei dem der Gleichspannungszwischenkreis und das Leistungsmodul auf zwei separate Platinen verteilt sind, die über entsprechende Verbindungen miteinander mechanisch und elektrisch verbunden werden müssen, kommt die erfindungsgemäße Lösung ohne zusätzliche mechanische und elektrische Verbindungen von zwei Platinen und somit ohne zusätzliches weiteres Befestigungsmaterial und Halter aus.

Die Leiterplatte ist in einem deckelartigen Gehäuseteil montiert. Dabei erfolgt die Montage derart, dass die Leiterplatte vom deckelartigen Gehäuseteil gehalten wird und in diesem fixiert ist.

Eine Kühlung des Gleichspannungszwischenkreises und insbesondere der Leistungshalbleiter des Leistungsmoduls wird gemäß der Erfindung dadurch sichergestellt, dass das deckelartige Gehäuseteil, in dem die Leiterplatte fixiert ist, auf einem Kühlkörper montiert ist.

Der Gleichspannungszwischenkreis und das Leistungsmodul des Umrichters weisen Leistungsstromanschlüsse mit Anschlussbolzen auf, über die der Umrichter an elektrische Einrichtungen angeschlossen werden kann. Hinsichtlich eines einfachen Bauaufwandes und einer einfachen Montage ergeben sich Vorteile, wenn die Anschlussbolzen gemäß der Erfindung im deckelartigen Gehäuseteil integriert sind.

Vorteilhafterweise ist mindestens ein Stromsensorring vorgesehen, der einen in einem Leistungsstromanschluss fließenden Strom erfasst. Der Sensorring kann beispielsweise aus ringförmigen Blechpaketen (Sensorkern) aufgebaut sein, die mindestens einen der Leistungsstromanschlüsse umschließen. Dabei wird ein Spalt gebildet, in dem ein Magnetsensor angeordnet ist, über den indirekt die Magnetfelder der fließenden Ströme erfasst werden können. Gemäß einer besonders bevorzugten Ausgestaltung der Erfindung ist der Stromsensorring im deckelartigen Gehäuseteil integriert.

Vorzugsweise ist das deckelartige Gehäuseteil aus einem, insbesondere isolierenden, Spritzgussmaterial gefertigt, beispielsweise Kunststoff. In diesem Fall sind die Anschlussbolzen zweckmäßigerweise im Spritzgussmaterial des deckelartigen Gehäuseteils mit eingespritzt. Auch der Stromsensorring ist vorteilhafterweise im Spritzgussmaterial des deckelartigen Gehäuseteils mit eingespritzt. Dadurch ist eine hohe Dichtigkeit, insbesondere Wasserdichtigkeit, automatisch gewährleistet. Das Spritzgussmaterial, insbesondere wenn es sich um einen Kunststoff handelt, umschließt die Anschlussbolzen beziehungsweise den Stromsensorring beim Abkühlen als Thermoplast oder beim Aushärten als Duroplast gasdicht. Hierzu werden die Anschlussbolzen beziehungsweise der Stromsensorring bei der Herstellung des deckelartigen Gehäuseteils in das Spritzgusswerkzeug eingelegt und mit dem Spritzgussmaterial umspritzt.

Eine besonders kostengünstige Bauweise mit verringertem Montageaufwand ergibt sich durch eine bevorzugte Ausgestaltung der Erfindung, bei der die Leiterplatte an einer Seite mittels Schrauben an den Anschlussbolzen geschraubt ist und auf der gegenüberliegenden Seite im deckelartigen Gehäuseteil eingerastet ist. Somit wird eine Seite der Leiterplatte automatisch durch die Schrauben an den im deckelartigen Gehäuseteil eingespritzten Anschlussbolzen und die gegenüberliegende Seite der Leiterplatte beispielsweise durch Rasthaken im deckelartigen Gehäuseteil fixiert.

Dabei ist zur weiteren Verringerung des Montageaufwands vorteilhafterweise vorgesehen, dass das deckelartige Gehäuseteil auf dem Kühlkörper eingerastet ist. Hierzu sind bevorzugt an dem deckelartigen Gehäuseteil mehrere Rasthaken vorgesehen, die mit Rastausnehmungen an dem Kühlkörper zusammenwirken. Das deckelartige Gehäuseteil ist somit mittels der Rasthaken an dem Kühlkörper befestigt. Somit ist keine Verschraubung des deckelartigen Gehäuseteils mit dem Kühlkörper notwendig.

In einer besonders bevorzugten Ausgestaltung der Erfindung erfolgt die Kühlanbindung der Leiterplatte an den Kühlkörper durch einen thermisch leitfähigen Kleber, welcher auch als Toleranzausgleich zwischen der Leiterplatte und dem Kühlkörper dient. Hierzu ist zwischen der im deckelartigen Gehäuseteil fixierten Leiterplatte und dem Kühlkörper ein wärmeleitfähiger Kleber vorgesehen.

Gemäß einer vorteilhaften Weiterbildung der Erfindung beinhaltet der Kleber Partikel mit einem Durchmesser von ca. 0,1 mm bis ca. 0,3 mm, insbesondere ca. 0,2 mm. Dabei sind die Partikel zweckmäßigerweise als Glaskügelchen ausgebildet. Dadurch ist ein minimaler Abstand der Leiterplatte zum Kühlkörper gewährleistet. Dieser Abstand ist zur Aufrechterhaltung der Isolationsfestigkeit zwischen der Leiterplatte und dem Kühlkörper wünschenswert.

Außerdem weist der wärmeleitfähige Kleber vorzugsweise eine Spannungsfestigkeit von ca. 8 kV/mm bis ca. 12 kV/mm, insbesondere ca. 10 kV/mm, auf.

Sollte sich der Spalt zwischen der Leiterplatte und dem Kühlkörper durch Temperaturschwankungen während des Betriebs verändern, wird der wärmeleitfähige Kleber die Leiterplatte fixieren, da dieser in sich elastisch ist.

Um einen minimalen Abstand der Leiterplatte zum Kühlkörper zu gewährleisten, ist gemäß einer alternativen Weiterbildung der Erfindung die Leiterplatte an der dem Kühlkörper zugewandten Unterseite mit Abstandshaltern bestückt. Mit derartigen an der Unterseite der Leiterplatte angeordneten Abstandhaltern, kann ebenfalls in einfacher Weise ein minimalen Spalt zwischen Kühlkörper und Leiterplatte sichergestellt werden. Hierzu können beispielsweise "Dummy"-Chip-Widerstände als Abstandhalter vorgesehen sein, welche auf die Unterseite der Leiterplatte gelötet werden. Diese "Dummy"-Chip-Widerstände haben keine elektrische Funktion, sondern dienen nur als Abstandshalter. Die Widerstände werden bevorzugt beim Lötprozess der Leiterplatte mit bestückt. Dies erleichtert die Montage, da kein zusätzlicher Montageschritt für die Montage der Abstandhalter an der Leiterplatte erforderlich ist. Die Chip-Widerstände weisen bevorzugt eine Bauhöhe von ca. 0,5mm auf, was dem geforderten Mindestabstand zwischen Leiterplatte und Kühlkörper entspricht. Mit derartigen als "Dummy"-Chip-Widerstände ausgebildeten Abstandshaltern werden somit keine separaten Abstandshalter, beispielsweise zusätzliche Plastikteile, benötigt.

Die Herstellung des erfindungsgemäßen Umrichters, insbesondere eines mehrphasigen Drehstromumrichters, mit einem Gleichspannungszwischenkreis und einem, mindestens einen Leistungshalbleiter aufweisenden, Leistungsmodul erfolgt durch folgende Schritte:
a) Aufbringen des Gleichspannungszwischenkreises und des Leistungsmoduls auf einer gemeinsamen Leiterplatte,
b) Fixieren der Leiterplatte in einem deckelartigen Gehäuseteil,
c) Beschichten eines Kühlkörpers mit einem wärmeleitfähigen Kleber,
d) Drücken des deckelartigen Gehäuseteils auf den Kühlkörper,
e) Verrasten des deckelartigen Gehäuseteils mit dem Kühlkörper und
f) Aushärten des Klebers, insbesondere durch Inbetriebnahme des Umrichters auf einem Prüfstand durch Erwärmung des Leistungsmoduls.

Eine Verschraubung zwischen dem deckelartigen Gehäuseteil und dem Kühlkörper ist für die Sicherstellung einer ausreichenden Kühlung der Leiterplatte nicht notwendig. Es genügt, die Leiterplatte in das deckelartige Gehäuseteil zu montieren, den Kühlkörper mit dem Kleber zu beschichten und das deckelartige Gehäuseteil auf den Kühlkörper zu drücken, so dass es in der korrekten Position verrastet.

Der wärmeleitfähige Kleber füllt den Spalt zwischen der Leiterplatte und dem Kühlkörper. Überflüssiges Material des Klebers drückt sich zur Seite weg. Eventuelle Toleranzen des Spaltes zwischen der Leiterplatte und dem deckelartigen Gehäuseteil werden somit ausgeglichen.

Der Kleber härtet durch chemische Reaktion mit der Luftfeuchtigkeit in Inneren des Umrichter-Gehäuses aus. Je nach verwendetem Kleber, beispielsweise einem 1-Komponenten-Kleber, ist für das Aushärten des Klebers ein Erwärmen nicht zwingend notwendig, ein Erwärmen kann jedoch das Aushärten des Klebers beschleunigen. Bei anderen Klebern, beispielsweise 2-Komponenten-Klebern, kann für das Aushärten des Klebers ein Erwärmen erforderlich sein, was bevorzugt bei der ersten Inbetriebnahme des Umrichters im Prüfstand erfolgt

Vor dem Schritt d) wird eine umlaufende Dichtung zwischen dem deckelartigen Gehäuseteil und dem Kühlkörper aufgebracht.

Dadurch kann in einfacher Weise eine Abdichtung zwischen dem deckelartigen Gehäuseteil und dem Kühlkörper erzielt werden. Hierzu kann bevorzugt automatisiert, beispielsweise mittels eines Automaten, eine umlaufende Dichtung, insbesondere Gummidichtung, appliziert werden.

Der gesamte Montagevorgang des erfindungsgemäßen Umrichters kann automatisiert werden.

Die Erfindung bietet eine ganze Reihe von Vorteilen:
Es wird eine einfache und kostengünstige Montage der Baugruppen des Umrichters ermöglicht. Durch das Einspritzen der Anschlussbolzen und der Stromsensorringe in das deckelartige Gehäuseteil ist deren Position fix. Es sind keine weiteren Montagematerialien erforderlich. Die Abdichtung der Anschlussbolzen zum deckelartigen Gehäuseteil ist damit einfach möglich. Die Toleranzkette Leiterplatte-Kühlkörper wird mittels des thermisch leitfähigen Klebers durchbrochen. Außerdem kann durch die Integration der Steuer- und Leistungselektronik auf einer gemeinsamen Leiterplatte eine erhebliche Verringerung des Bauvolumens des Umrichters erreicht werden.

Weitere Vorteile und Einzelheiten der Erfindung werden anhand des in den schematischen Figuren dargestellten Ausführungsbeispiels näher erläutert. Hierbei zeigen
- Figur 1: eine perspektivische Explosionsdarstellung des erfindungsgemäßen Umrichters,
- Figur 2: eine Schnittansicht des deckelartigen Gehäuseteils mit darin montierter Leiterplatte,
- Figur 3: eine Schnittansicht des erfindungsgemäßen Umrichters,
- Figur 4: eine perspektivische Unteransicht des deckelartigen Gehäuseteils ohne Leiterplatte und
- Figur 5: eine perspektivische Explosionsdarstellung des deckelartigen Gehäuseteils.

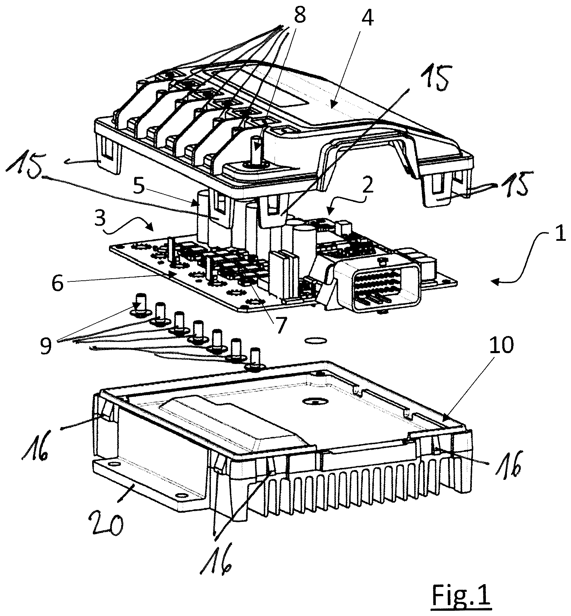

In Figur 1 ist ein Umrichter 1, beispielsweise ein dreiphasiger Drehstromumrichter als Frequenzumrichter, zur Ansteuerung eines elektrischen Motors dargestellt.

Der Umrichter 1 weist einen Gleichspannungszwischenkreis 2 und ein Leistungsmodul 3 auf, die auf einer gemeinsamen Leiterplatte 6, bevorzugt einer IMS-Leiterplatte, untergebracht sind. Die Leiterplatte 6 ist mit Kondensatoren 5 des Gleichspannungszwischenkreises 2 und mit Leistungshalbleitern 7, beispielsweise Leistungstransistoren, des Leistungsmoduls 3 sowie weiteren diskreten Bauteilen bestückt. Die Leiterplatte 6 umfasst somit die Leistungs- und Steuerungselektronik sowie die entsprechende Sensorik.

Die Leiterplatte 6 wird bei der Montage des Umrichters 1 in das deckelartige Gehäuseteil 4 des Umrichters 1 eingesetzt. Das deckelartige Gehäuseteil 4 besteht aus einem Spritzgussmaterial, in das die elektrischen Anschlussbolzen 8 der Leistungsstromanschlüsse des Gleichspannungszwischenkreises 2 und des Leistungsmoduls 3 eingespritzt sind. Dadurch ist eine Wasserdichtigkeit automatisch gegeben. Weiterhin sind in das deckelartige Gehäuseteil 4 in der Figur 1 nicht näher dargestellte Stromsensorkerne an entsprechenden Anschlussbolzen 8 eingespritzt.

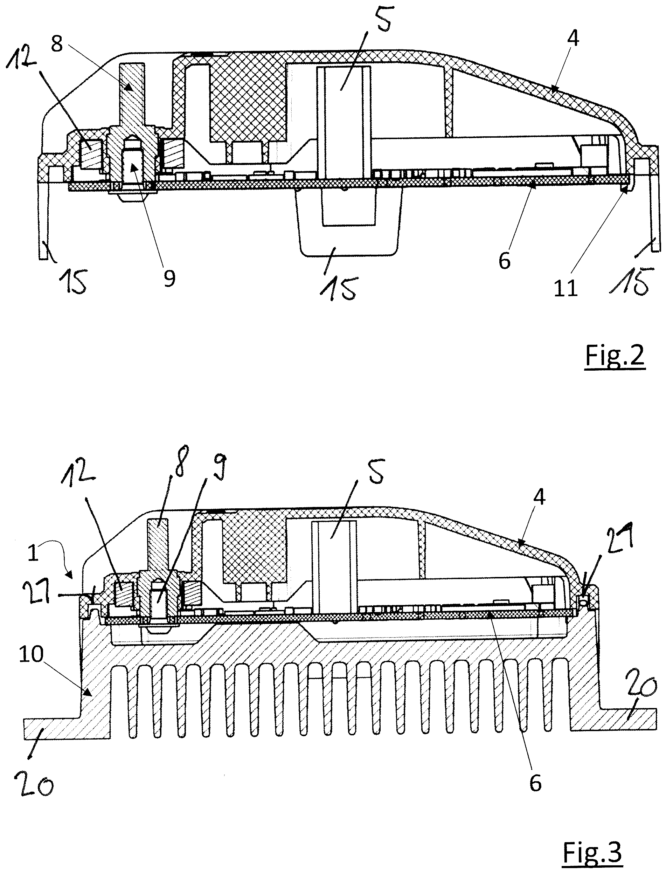

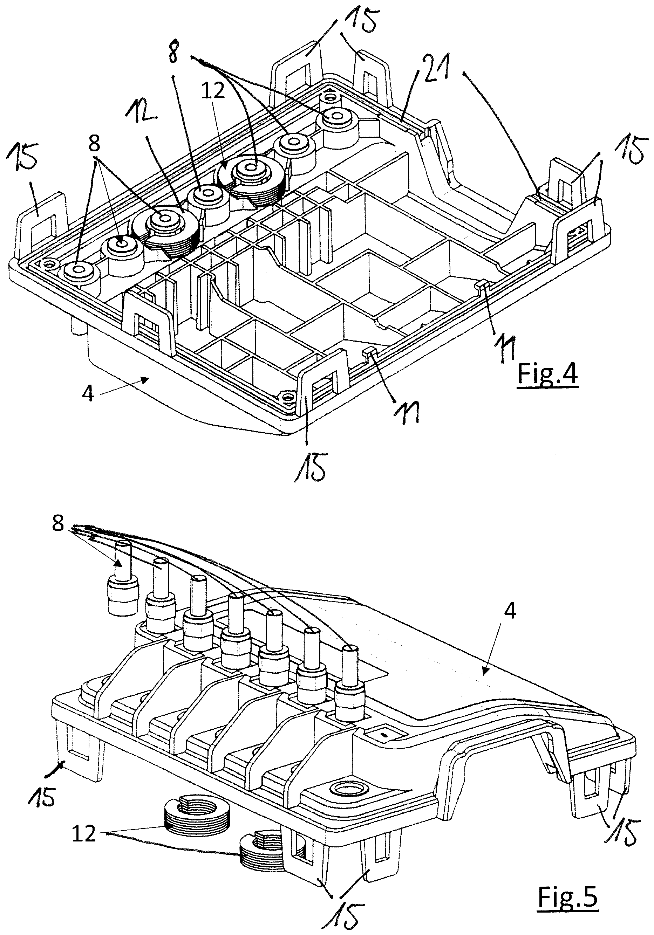

An die im Gehäuseteil 4 eingespritzten Anschlussbolzen 8 wird eine Seite der Leiterplatte 6 bei der Montage des Umrichters 1 mittels Schrauben 9 geschraubt. Die Anschlussbolzen 8 sind hierzu - wie in Figur 2 näher dargestellt ist - mit Gewindebohrungen versehen, in die jeweils eine Schraube 9 eingeschraubt werden kann. Mit den Schrauben 9 wird die Leiterplatte 6 elektrisch und mechanisch mit den Anschlussbolzen 8 verbunden. Die gegenüberliegende Seite der Leiterplatte 6 wird am deckelartigen Gehäuseteil 4 - wie in Figur 2 näher dargestellt ist - eingerastet. Das deckelartige Gehäuseteil 4 ist hierzu - wie in Figur 4 näher dargestellt ist - mit mehreren Rasthaken 11 versehen, in die die Leiterplatte 6 eingeschoben werden kann. Somit wird die Leiterplatte 6 im deckelartigen Gehäuseteil 4 fixiert.

Um eine ausreichende Kühlung des Gleichspannungszwischenkreises 2 und des Leistungsmoduls 3, insbesondere der Leistungshalbleiter 7, während des Betriebs des Umrichters 1 sicherzustellen, ist ein Kühlkörper 10 des Umrichters 1 vorgesehen. Der Kühlkörper 10 wird vor der Montage des Umrichters 1 mit einem wärmeleitfähigen Kleber beschichtet. Anschließend wird das deckelartige Gehäuseteil 4 mit der darin montierter Leiterplatte 6 auf den Kühlkörper 10 aufgesetzt und eingerastet. An dem deckelartigen Gehäuseteil 4 sind zur Befestigung an dem Kühlkörper 10 mehrere Rasthaken 15 ausgebildet, die mit Rastausnehmungen 16, beispielsweise Rastnasen, an dem Kühlkörper 10 zusammenwirken.

Der Kühlkörper 10 ist mit einem Befestigungsflansch 20 versehen, mit dem der Umrichter 1 an einer Maschine, beispielsweis einem Flurförderzeug, befestigt werden kann.

Die Figur 2 zeigt eine Schnittansicht des deckelartigen Gehäuseteils 4 mit darin montierter Leiterplatte 6. In dieser Darstellung ist zu erkennen, wie die Leiterplatte 6 im deckelartigen Gehäuseteil 4 fixiert ist. Eine Seite der Leiterplatte 6 ist mittels der Schrauben 9 an die, in das deckelartige Gehäuseteil 4 eingespritzten Anschlussbolzen 8 geschraubt. Die gegenüberliegende Seite der Leiterplatte 6 ist in die Rasthaken 11 des deckelartigen Gehäuseteils 4 eingeführt und am deckelartigen Gehäuseteil 4 eingerastet.

In der Figur 3 ist eine Schnittansicht des erfindungsgemäßen Umrichters 1 dargestellt. Diese Darstellung zeigt den Umrichter 1 im bereits montierten Zustand. Dabei ist das deckelartige Gehäuseteil 4 mit darin fixierter Leiterplatte 6 auf den Kühlkörper 10 aufgesetzt. Die Oberseite des Kühlkörpers 10 ist mit einem wärmeleitfähigen Kleber beschichtet, der die Kühlanbindung der Leiterplatte 6 an den Kühlkörper 10 sicherstellt und zusätzlich als Toleranzausgleich zwischen der Leiterplatte 6 und dem Kühlkörper 10 dient. Bei der Montage des Umrichters 1 wird das deckelartige Gehäuseteil 4 mit der darin montierten Leiterplatte 6 auf den, mit dem wärmeleitfähigen Kleber beschichteten, Kühlkörper 10 gedrückt und verrastet dann mittels der mit den Rastausnehmungen 16 zusammenwirkenden Rasthaken 15 in der korrekten Position.

Um eine Abdichtung zwischen dem deckelartigen Gehäuse 4 und dem Kühlkörper 10 des Umrichters 1 zu erzielen, ist das deckelartige Gehäuse 4 mit einer umlaufenden Nut 21 versehen, in die eine umlaufende Dichtung eingelegt werden kann. Die Dichtung wird bevorzugt als Gummidichtung ausgebildet, die automatisiert mittels eines Automaten am deckelartigen Gehäuse 4 aufgebracht wird.

Die Figur 4 zeigt eine perspektivische Unteransicht des deckelartigen Gehäuseteils 4 ohne Leiterplatte 6. In dieser Darstellung sind die in das deckelartige Gehäuseteils 4 mit eingespritzten Anschlussbolzen 8 und eingespritzte Stromsensorringe 12 (Sensorringe) an entsprechenden Anschlussbolzen 8 gut zu erkennen.

In der Figur 5 ist eine perspektivische Explosionsdarstellung des deckelartigen Gehäuseteils 4 mit den Anschlussbolzen 8 und den Stromsensorringen 12 der Figur 4 dargestellt.

## Patentansprüche

1. Umrichter (1), insbesondere mehrphasiger Drehstromumrichter, mit einem Gleichspannungszwischenkreis (2) und einem, mindestens einen Leistungshalbleiter (7) aufweisenden, Leistungsmodul (3), wobei der Gleichspannungszwischenkreis (2) und das Leistungsmodul (3) auf einer gemeinsamen Leiterplatte (6) untergebracht sind, wobei die Leiterplatte (6) in einem deckelartigen Gehäuseteil (4) fixiert ist und das deckelartige Gehäuseteil (4) auf einem Kühlkörper (10) montiert ist, **dadurch gekennzeichnet, dass** im deckelartigen Gehäuseteil (4) Anschlussbolzen (8) von Leistungsstromanschlüssen des Gleichspannungszwischenkreises (2) und des Leistungsmoduls (3) integriert sind.

2. Umrichter (1) nach Anspruch 1, **dadurch gekennzeichnet, dass** im deckelartigen Gehäuseteil (4) mindestens ein Stromsensorring (12), der mindestens einen Leistungsstromanschluss des Gleichspannungszwischenkreises (2) und/oder des Leistungsmoduls (3) umschließt, integriert ist.

3. Umrichter (1) nach Anspruch 1 oder 2, **dadurch gekennzeichnet, dass** das deckelartige Gehäuseteil (4) aus einem Spritzgussmaterial gefertigt ist.

4. Umrichter (1) nach Anspruch 3, **dadurch gekennzeichnet, dass** die Anschlussbolzen (8) im Spritzgussmaterial des deckelartigen Gehäuseteils (4) mit eingespritzt sind.

5. Umrichter (1) nach Anspruch 3 oder 4, **dadurch gekennzeichnet, dass** der Stromsensorring (12) im Spritzgussmaterial des deckelartigen Gehäuseteils (4) mit eingespritzt ist.

6. Umrichter (1) nach einem der Ansprüche 1 bis 5, **dadurch gekennzeichnet, dass** die Leiterplatte (6) an einer Seite mittels Schrauben (9) an den Anschlussbolzen (8) geschraubt ist und auf der gegenüberliegenden Seite im deckelartigen Gehäuseteil (4) eingerastet ist.

7. Umrichter (1) nach einem der Ansprüche 1 bis 6, **dadurch gekennzeichnet, dass** das deckelartige Gehäuseteil (4) auf dem Kühlkörper (10) eingerastet ist.

8. Umrichter (1) nach einem der Ansprüche 1 bis 7, **dadurch gekennzeichnet, dass** zwischen der im deckelartigen Gehäuseteil (4) fixierten Leiterplatte (6) und dem Kühlkörper (10) ein wärmeleitfähiger Kleber vorgesehen ist.

9. Umrichter (1) nach Anspruch 8, **dadurch gekennzeichnet, dass** der Kleber Partikel mit einem Durchmesser von ca. 0,1 mm bis ca. 0,3 mm, insbesondere ca. 0,2 mm, beinhaltet.

10. Umrichter (1) nach Anspruch 9, **dadurch gekennzeichnet, dass** die Partikel als Glaskügelchen ausgebildet sind.

11. Umrichter (1) nach einem der Ansprüche 8 bis 10, **dadurch gekennzeichnet, dass** der wärmeleitfähige Kleber eine Spannungsfestigkeit von ca. 8 kV/mm bis ca. 12 kV/mm, insbesondere ca. 10 kV/mm, aufweist.

12. Umrichter nach einem der Ansprüche 1 bis 8, dass die Leiterplatte (6) an der dem Kühlkörper (10) zugewandten Unterseite mit Abstandshaltern bestückt ist.

## Claims

1. Inverter (1), in particular multiphase three-phase Inverter, having a DC link (2) and a power module (3), which comprises at least one power semiconductor (7), wherein the DC link (2) and the power module (3) are accommodated on a common printed circuit board (6), wherein the printed circuit board (6) is fixed in a cover-like housing part (4) and the cover-like housing part (4) is mounted on a heat sink (10), **characterized in that** connector pins (8) of electrical power connections of the DC link (2) and of the power module (3) are integrated in the cover-like housing part (4).

2. Inverter (1) according to Claim 1, **characterized in that** at least one current sensor ring (12), which surrounds at least one electrical power connection of the DC link (2) and/or of the power module (3), is integrated in the cover-like housing part (4).

3. Inverter (1) according to Claim 1 or 2, **characterized in that** the cover-like housing part (4) is made of an injection-moulded material.

4. Inverter (1) according to Claim 3, **characterized in that** the connector pins (8) are also injection-moulded in the injection-moulded material of the cover-like housing part (4).

5. Inverter (1) according to Claim 3 or 4, **characterized in that** the current sensor ring (12) is also injection-moulded in the injection-moulded material of the cover-like housing part (4).

6. Inverter (1) according to one of Claims 1 to 5, **characterized in that** the printed circuit board (6) on one side is screwed to the connector pins (8) by means of screws (9) and on the opposite side is latched in the cover-like housing part (4).

7. Inverter (1) according to one of Claims 1 to 6, **characterized in that** the cover-like housing (4) is latched onto the heat sink (10).

8. Inverter (1) according to one of Claims 1 to 7, **characterized in that** a thermally conductive adhesive is provided between the printed circuit board (6), which is fixed in the cover-like housing part (4), and the heat sink (10).

9. Inverter (1) according to Claim 8, **characterized in that** the adhesive contains particles with a diameter of approximately 0.1 mm to approximately 0.3 mm, in particular approximately 0.2 mm.

10. Inverter (1) according to Claim 9, **characterized in that** the particles are in the form of glass beads.

11. Inverter (1) according to one of Claims 8 to 10, **characterized in that** the thermally conductive adhesive has a dielectric strength of approximately 8 kV/mm to approximately 12 kV/mm, in particular proximately 10 kV/mm.

12. Inverter according to one of Claims 1 to 8, **characterized in that** the printed circuit board (6) is populated with spacers on the bottom side remote from the heat sink (10).

## Revendications

1. Convertisseur (1), en particulier convertisseur polyphasé, comprenant un circuit intermédiaire continu (2) et un module de puissance (3) comportant au moins un semi-conducteur de puissance (7), le circuit intermédiaire continu (2) et le module de puissance (3) étant monté sur une carte de circuit imprimé commune (6), la carte de circuit imprimé (6) étant fixée dans une partie de boîtier (4) en forme de couvercle et la partie de boîtier (4) en forme de couvercle étant montée sur un dissipateur thermique (10), **caractérisé en ce que** des boulons de raccordement (8) de bornes de courant de puissance du circuit intermédiaire continu (2) et du module de puissance (3) sont intégrés dans la partie de boîtier (4) en forme de couvercle.

2. Convertisseur (1) selon la revendication 1, **caractérisé en ce qu'**au moins une bague formant capteur de courant (12), qui enserre au moins une borne de courant de puissance du circuit intermédiaire continu (2) et/ou du module de puissance (3), est intégrée dans la partie de boîtier (4) en forme de couvercle.

3. Convertisseur (1) selon la revendication 1 ou 2, **caractérisé en ce que** la partie de boîtier (4) en forme de couvercle est fabriquée à partir d'une matière moulée par injection.

4. Convertisseur (1) selon la revendication 3, **caractérisé en ce que** les boulons de raccordement (8) sont incorporés dans la matière de moulage par injection de la partie de boîtier (4) en forme de couvercle.

5. Convertisseur (1) selon la revendication 3 ou 4, **caractérisé en ce que** la bague formant capteur de courant (12) est incorporée dans la matière de moulage par injection de la partie de boîtier (4) en forme de couvercle.

6. Convertisseur (1) selon l'une des revendications 1 à 5, **caractérisé en ce que** la carte de circuit imprimé (6) est vissée au boulon de raccordement (8) sur un côté au moyen de vis (9) et est encliquetée du côté opposé dans la partie de boîtier (4) en forme de couvercle.

7. Convertisseur (1) selon l'une des revendications 1 à 6, **caractérisé en ce que** la partie de boîtier (4) en forme de couvercle est encliquetée sur le dissipateur thermique (10).

8. Convertisseur (1) selon l'une des revendications 1 à 7, **caractérisé en ce qu'**un adhésif thermoconducteur est prévu entre la carte de circuit imprimé (6) fixée dans la partie de boîtier (4) en forme de couvercle et le dissipateur thermique (10).

9. Convertisseur (1) selon la revendication 8, **caractérisé en ce que** l'adhésif contient des particules d'un diamètre d'environ 0,1 mm à environ 0,3 mm, notamment d'environ 0,2 mm.

10. Convertisseur (1) selon la revendication 9, **caractérisé en ce que** les particules sont conçues sous forme de billes de verre.

11. Convertisseur (1) selon l'une des revendications 8 à 10, **caractérisé en ce que** l'adhésif thermoconducteur présente une rigidité diélectrique d'environ 8 kV/mm à environ 12 kV/mm, notamment d'environ 10 kV/mm.

12. Convertisseur selon l'une des revendications 1 à 8, **caractérisé en ce que** la carte de circuit imprimé (6) est équipée d'entretoises sur le côté inférieur dirigé vers le dissipateur thermique (10).
